# EUROPEAN PATENT APPLICATION

(11) **EP 4 708 694 A2**
(43) Date of publication of application: **11.03.2026**
(21) Application number: 26153295.6
(22) Date of filing: 05.02.2025
(51) Int. Cl.: H03K 17/955

(54) **CAPACITANCE SENSOR AND ROBOT SYSTEM**

(30) Priority: 09.02.2024 JP 2024018350
(62) Divisional of application: 25156087.6
(71) Applicant: The University of Tokyo, Bunkyo-ku, Tokyo 113-8654 (JP); Nachi-Fujikoshi Corp., Tokyo 105-0021 (JP)
(72) Inventor: OKUNO, Akira, Tokyo, 113-8654 (JP); YAMAMOTO, Akio, Tokyo, 113-8654 (JP); MIKI, Daiki, Toyama, 930-0965 (JP)
(74) Representative: Plougmann Vingtoft a/s

(57) **Abstract**

A capacitance sensor (6) is capable of correcting an object detection result irrespective of changes in ambient air conditions and capable of simplifying a configuration for the correction. The capacitance sensor (6) includes a detection sensor (11) including a detection electrode (25) and configured to output a sensed value representing a capacitance created between the detection electrode (25) and an object such as a human worker (H). The sensor includes a reference electrode (12) provided to face the detection electrode (25) and coupled to a reference potential via a switch (30b). The sensor also includes a processing device (13) that controls opening/closing of the switch (30b) to transition between a first state in which the reference electrode (12) is opened and a second state in which the reference electrode (12) is coupled to the reference potential.

## Description

### TECHNICAL FIELD

The present invention relates to a capacitance sensor and a robot system.

### BACKGROUND ART

There are occasions where a human worker and a robot collaborate with each other to perform an operation on a workpiece. The robot used in such occasions is called a collaborative robot. Since the collaborative robot shares the same work space with a human worker, the human worker safety needs to be ensured. For this purpose, a capacitance sensor that is capable of detecting the presence of a proximate object is sometimes mounted on the collaborative robot.

the capacitance sensor is notorious in being prone to a sensing drift caused by ambient temperature and humidity changes. When a sensing drift occurs, it is possible that the detection accuracy is compromised. Especially when a sensing range, within which the capacitance sensor is required to operate for detection, is set long, the influence of the drift becomes non-negligible.

For example, Patent Literature 1 teaches a capacitance sensor that uses a detection electrode and a reference electrode to correct, using a signal from the reference electrode, fluctuations of a signal of the detection electrode caused by changes in the ambient state including an ambient temperature and an ambient humidity.

### CITATION LIST

### PATENT LITERATURE

Patent Literature 1: JP 2006-145413 A

### SUMMARY OF INVENTION

However, the capacitance sensor taught in Patent Literature 1 has a problem in that a special arrangement is necessary to be set up to prevent an object from being detected by the reference electrode, whose purpose for correction of a sensing signal. The special arrangement required to be set up for Patent Literature 1 includes setting up a preventive circumstance that provides a sufficiently large space or a shield or the like around the reference electrode.

In view of the above-mentioned problems, the present invention is contemplated to provide a capacitance sensor and a robot system that are capable of correcting a sensing drift in the object detection signal, caused by changes in the ambient state, with a simplified configuration.

To solve the above-mentioned issue, a capacitance sensor according to the present invention includes a detection sensor that includes a detection electrode and is configured to output a sensed value representing a capacitance created between the detection electrode and an object. The capacitance sensor also includes a reference electrode provided to face the detection electrode and coupled to a reference potential via a switch. The sensor also includes a processing device that controls opening/closing of the switch to transition between a first state in which the reference electrode is opened and a second state in which the reference electrode is coupled to the reference potential.

The processing device of the capacitance sensor corrects the sensed value measured in the first state with the sensed value measured in the second state.

The sensed value measured in the first state is a value representing a capacitance created between the detection electrode and the object via the opened reference electrode, and the sensor value measured in the second state is a value representing a capacitance created between the detection electrode and the reference electrode coupled to the reference potential.

In another aspect of the present invention, a capacitance sensor includes a detection sensor that includes a detection electrode and is configured to output a sensed value representing a capacitance created between the detection electrode and an object. the capacitance sensor includes a reference sensor provided at a position that is different from a position of the detection electrode and including electrodes paired via ambient air. The capacitance sensor further includes a processing device that calculates a dielectric constant of the ambient air based on an output from the reference sensor and that corrects the sensed value with the dielectric constant.

The detection electrode in the detection sensor and the reference sensor are provided to different members.

The detection sensor is provided in plural, the reference sensor is provided with respect to the plural detection sensors, and the processing device uses the dielectric constant calculated from an output from the reference sensor to correct the sensed value measured by each of the plural detection sensors.

In another aspect of the present invention, a robot system includes a base, a plurality of arms provided to the base and the capacitance sensor described in the previous paragraphs. The detection electrode and the reference electrode are provided in any of the plurality of arms.

In another aspect of the present invention the robot system includes a base, a plurality of arms provided to the base and the capacitance sensor described in the previous paragraphs. The detection electrode in the detection sensor is provided in any of the plurality of arms, and the reference sensor is provided in the base.

The capacitance sensor and the robot system according to the present invention make it possible to correct a sensing drift in the object detection signal, caused by changes in the ambient state, with a simplified configuration.

### BRIEF DESCRIPTION OF DRAWINGS

FIG. 1 is a schematic view illustrating an example of an overall configuration of a robot system equipped with a capacitance sensor according to a first embodiment of the present invention.
FIG. 2 is a block diagram illustrating an exemplary configuration of the capacitance sensor illustrated in FIG. 1.
FIG. 3 is a conceptual view illustrating a first state in which the capacitance sensor illustrated in FIG. 1 operates.
FIG. 4 is a conceptual view illustrating a second state in which the capacitance sensor illustrated in FIG. 1 operates.
FIG. 5 is a flowchart showing an exemplary flow of processing steps executed by the processing device illustrated in FIG. 1.
FIG. 6 is a schematic view illustrating an exemplary configuration of a robot system equipped with a capacitance sensor according to a second embodiment.
FIG. 7 is a block diagram illustrating an exemplary configuration of the capacitance sensor illustrated in FIG. 6.
FIG. 8 is a flowchart showing describing an exemplary flow of processing steps executed by the processing device illustrated in FIG. 6.

### DESCRIPTION OF EMBODIMENTS

Embodiments of the present invention will be described below with reference to the accompanying drawings. Note that in each drawing, an identical constituent element is denoted using an identical reference number wherever possible for facilitating understanding, and an overlapping description is omitted when appropriate.

### First Embodiment

First, a first embodiment is described.

### <Overall Configuration>

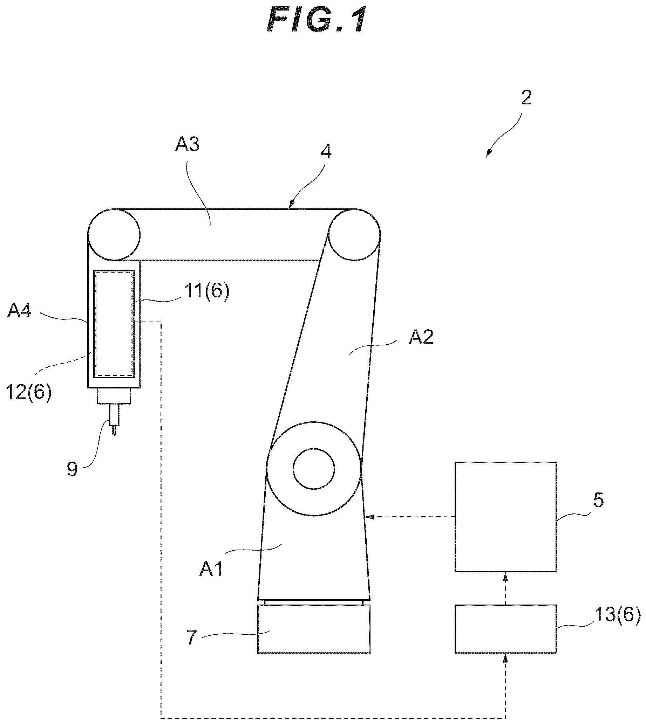

FIG. 1 is a schematic view illustrating an exemplary configuration of a robot system 2 equipped with a sensor 6 that is a capacitance sensor according to the first embodiment of the present invention. The sensor 6, i.e., a capacitance sensor, may be a proximity sensor or a displacement sensor. That is, the sensor 6 may be a sensor that detects a proximity or a sensor that detects a displacement. In the present embodiment, a description will be given using a proximity sensor as an example of the sensor 6. Note that the sensor 6 outputs a signal that changes according to a distance to a proximate object and is referred to as a "sensed value".

The robot system 2 is, for example, an industrial robot that performs processing such as processing and conveying a workpiece. Alternatively, the robot system 2 may, for example, be a collaborative robot that shares the same work space with a human worker while performing an operation.

As illustrated in FIG. 1, the robot system 2 mainly includes a robot 4, a control device 5, and the sensor 6.

The robot 4 is a multijoint robot and includes a plurality of arms and a plurality of joints. Specifically, the robot 4 includes a base 7, a first arm A1, a second arm A2, a third arm A3, and a fourth arm A4. Note that the number of arms to be mounted on the robot is not limited thereto. The base 7 is a base for the robot 4 and is provided on an installation surface on which the robot 4 is disposed. The base 7 is fixed to a floor surface and supports the entire robot 4. The first arm A1, the second arm A2, the third arm A3, and the fourth arm A4 are a plurality of arms mounted on the base 7. The first arm A1 is connected to the base 7 via a pivot axis. Additionally, the first arm A1 is configured to pivot about the pivot axis with respect to the base 7 by means of a motor, which is not illustrated. The second arm A2 is connected to the first arm A1 via a pivot axis and configured to pivot about the pivot axis by means of the motor, which is not illustrated. The third arm A3 is connected to the second arm A2 via a pivot axis and configured to pivot about the pivot axis by means of the motor, which is not illustrated. The fourth arm A4 is connected to the third arm A3 via a pivot axis and configured to pivot about the pivot axis by means of the motor, which is not illustrated. A distal end of the fourth arm A4 is provided with a tool 9. By operating each joint, the robot 4 performs prescribed operations and operates the tool 9 to perform a prescribed process on a workpiece.

The control device 5 is an information processing device that controls operations of the robot 4. The control device 5 includes, for example, a central processing unit (CPU), a memory, a communication device, and a storage device, and executes certain programs to implement various kinds of functions. The control device 5 directs operations of each arm of the robot 4 and the tool 9 to control the robot 4 to execute prescribed operations. The prescribed operations executed by the robot 4 under the control of the control device 5 include, for example, an operation of gripping a workpiece with the tool 9 and an operation of conveying the workpiece from a position to a different position.

Additionally, the control device 5 uses a sensed value output from the sensor 6, to be described later in detail, to place the operation of the robot 4 on hold. Specifically, if the sensor 6 is a proximity sensor, the control device 5 compares the sensed value with a threshold value, and determines whether or not an object, such as a human worker, is present within a close proximity to the robot 4. Upon a determination that the sensed value indicates that an object is present within a close proximity to the robot 4, the control device 5 places the operation of the robot 4 on hold. For example, when the sensed value increases as the object approaches, the control device 5 determines that the object is present in a close proximity if the sensed value becomes the threshold value or more. For example, when the sensed value decreases as the object approaches, the control device 5 determines that the object is in a close proximity if the sensed value becomes a threshold value or less. For example, if it is found that a human worker who is working with the robot 4 has come in a close proximity to the robot 4, the robot 4's operation is placed on hold even in the middle of performing a prescribed operation. Note that if the sensor 6 is the displacement sensor, the control device 5 acquires a detection result from the sensor 6 regarding a displacement and performs the process for holding the operation of the robot.

The sensor 6 is a capacitance sensor that detects an object such as a human worker. The sensor 6 mainly includes a detection sensor 11, a reference electrode 12, and a processing device 13.

The detection sensor 11 is a capacitance sensor that detects the presence of an object. The detection sensor 11 is provided in the robot 4. For example, the detection sensor 11 is provided in an arm of the robot 4. In the present embodiment, a description will be given using the detection sensor 11 that is provided in the fourth arm A4 for example. Note that the detection sensor 11 may be provided in another part of the robot 4 or provided in each of a plurality of arms, and locations for installation thereof are not restrictive.

Note that the description has been given using the detection sensor 11 that is provided in the arm in the above-mentioned examples. However, it is sufficient as long as at least a detection electrode 25, described later in detail, of the detection sensor 11 is provided in the arm, and other components of the detection sensor 11 may not be provided in the arm.

The detection sensor 11 detects the presence of an object that comes in a close proximity to the detection sensor 11 within a detection area located in a predetermined direction.

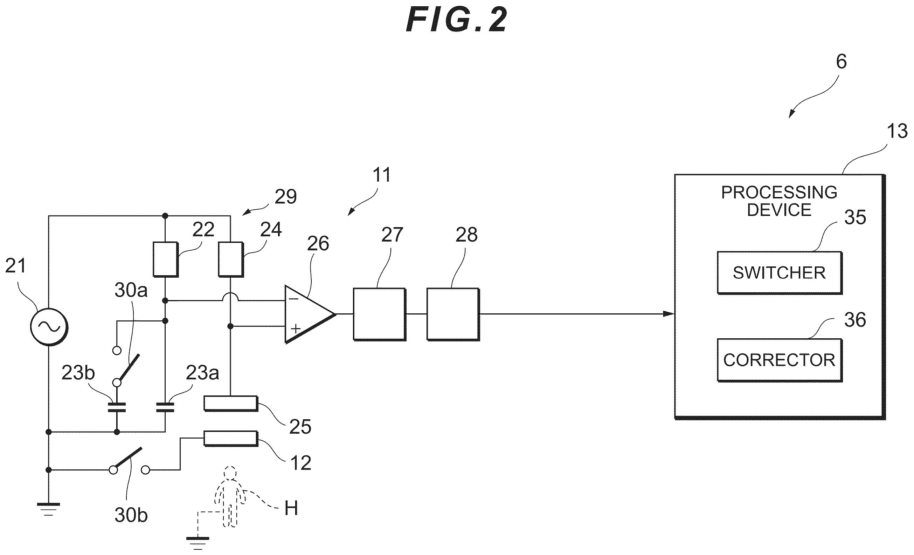

FIG. 2 is a block diagram illustrating an exemplary configuration of the sensor 6. The detection sensor 11 includes a selectable waveform generator 21, a resistor 22, a capacitor 23a, a capacitor 23b, a resistor 24, the detection electrode 25, an operational amplifier 26, a lock-in amplifier 27, and an analog/digital (A/D) converter 28. The resistor 22, the capacitor 23a, the capacitor 23b, the resistor 24, and the detection electrode 25 constitute a resistor-capacitor (RC) bridge circuit 29.

The selectable waveform generator 21 generates a sinusoidal waveform voltage or a rectangular waveform voltage having a predetermined frequency with respect to a ground potential (GND potential) serving as a reference potential, which is input to the RC bridge circuit 29. One end of the resistor 22 is electrically coupled to the selectable waveform generator 21, and the other end thereof is electrically coupled to the capacitor 23a. One end of the capacitor 23a is electrically coupled to the resistor 22, and the other end thereof is electrically coupled to the reference potential of the selectable waveform generator 21. The capacitor 23b is electrically coupled in parallel to the capacitor 23a via a switch 30a. One end of the resistor 24 is electrically coupled to the selectable waveform generator 21, and the other end thereof is electrically coupled to the detection electrode 25. The resistor 22, the capacitor 23a, the capacitor 23b, and the resistor 24 have preset values. For example, the resistors 22 and 24 may have a common resistance value.

The detection electrode 25 is electrically coupled to the resistor 24. The detection electrode 25 is, for example, in a flat plate shape and generates an electric field. The area of the generated electric field serves as an area for detection or a detection area, and an object that enters in the detection area is detected. A shield electrode coupled to the reference potential or an active shield electrode charged at the same potential as that of the detection electrode 25 may be provided on the opposite side of the detection area of the detection electrode 25.

Specifically, the detection electrode 25 creates a capacitance between the detection electrode 25 and an object. FIG. 2 illustrates a human worker H as an example of the object. It is assumed that the human worker H has the same potential as that of the reference potential. The detection electrode 25 creates a capacitance between the detection electrode 25 and the human worker H, which constitutes part of the RC bridge circuit 29.

An inverting input terminal of the operational amplifier 26 is electrically coupled between the resistor 22 and the capacitor 23a, and a non-inverting input terminal is electrically coupled between the resistor 24 and the detection electrode 25. An output terminal is electrically coupled to the lock-in amplifier 27. The lock-in amplifier 27 uses a signal from the selectable waveform generator 21 as a reference signal for synchronous waveform detection. The operational amplifier 26 performs a differential amplification to amplify a difference of voltages applied to the inverting input terminal and the non-inverting input terminal. The signal differentially amplified is subjected to the synchronous waveform detection at the lock-in amplifier 27 and converted from an analog signal to a digital signal at the A/D converter 28. The digital signal is output as a sensed value to the processing device 13, which will be described later in detail. In this manner, the sensed value output from the detection sensor 11 turns into a value corresponding to the capacitance created according to a state (distance) between the detection electrode 25 and the object. Note that the sensed value is not limited in the form of an output from the A/D converter 28. For example, an output from the lock-in amplifier 27 may be used as the sensed value.

As long as the output sensed value corresponds to the capacitance created at the detection electrode 25 a specific circuit configuration of the detection sensor 11 is not limited to that illustrated in FIG. 2.

The reference electrode 12 is positioned to face the detection electrode 25. The reference electrode 12 is positioned at a predetermined distance from the detection electrode 25 in a direction of the detection area. Hence, the reference electrode 12 is positioned at a substantially identical location to the detection electrode 25. The reference electrode 12 is provided in the arm as is the detection electrode 25. The reference electrode 12 is, for example, in a flat plate shape.

The reference electrode 12 is coupled to the reference potential via a switch 30b. The switch 30b is controlled open and close by the processing device 13, which will be described later in detail. When the switch 30b is in an open state, the reference electrode 12 is in an open state. When the switch 30b is in a closed state, the reference electrode 12 is placed in connection to the reference potential (grounded state). The open state of the reference electrode 12 is referred to as a "first state", and the state in which the reference electrode 12 is coupled to the reference potential is referred to as a "second state".

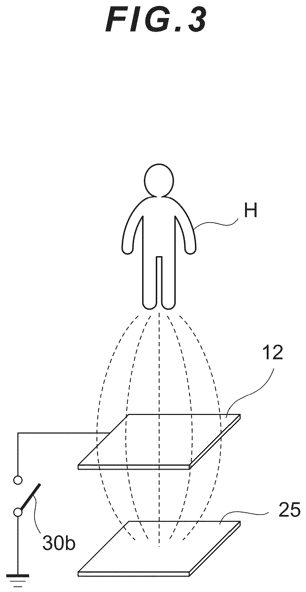

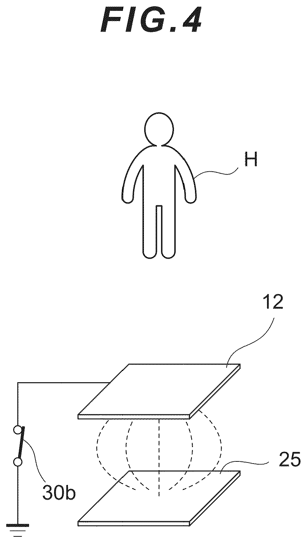

The reference electrode 12 is switched between the first state and the second state. FIG. 3 is a conceptual view illustrating the first state. FIG. 4 is a conceptual view illustrating the second state. As illustrated in FIG. 3, in the first state, an electric field generated by the detection electrode 25 passes through the reference electrode 12. A capacitance is created between the detection electrode 25 and the human worker H depends on the distance between the detection electrode 25 and the human worker H. Since the switch 30b is in the open state, the reference electrode 12 is in the open state. Hence, the influence of the reference electrode 12 on the electric field generated by the detection electrode 25 is negligible. For this reason, in the first state, the sensed value output from the detection sensor 11 turns into a value corresponding to the capacitance created via the opened reference electrode 12 between the detection electrode 25 and the object such as the human worker H.

In the second state, since the switch 30b is in the closed state, the reference electrode 12 is coupled to the reference potential as illustrated in FIG. 4. Thus, the electric field generated by the detection electrode 25 does not pass through the reference electrode 12, and thus a capacitance is created only between the detection electrode 25 and the reference electrode 12. For this reason, in the second state, the sensed value output from the detection sensor 11 turns into a value corresponding to a capacitance created between the detection electrode 25 and the reference electrode 12 coupled to the reference potential. The reference electrode 12 preferably has a size (area) equal to the size of the detection electrode 25 or a size (area) larger than the size of the detection electrode 25. The reference electrode 12 so configured can suppress the electric field generated by the detection electrode 25 from leaking from the reference electrode 12, and can suppress the influence of the object such as the human worker H.

In the first state and the second state, air capacitances are created. In the first state and the second state, the air capacitances are created under the equal ambient air conditions. In a parallel-plate capacitor, the ambient air conditions affect its dielectric constant ε and change the capacitance value thereof. Specifically, the dielectric constant ε is affected and changed by a temperature and a humidity (a relative humidity or an absolute humidity). The dielectric constant ε tends to be affected especially by the absolute humidity. The change in the dielectric constant ε becomes a cause for a sending drift of the sensed value. To address this, by switching the reference electrode 12 to the second state, it becomes possible to obtain the sensed value under the same ambient air conditions as in the first state in which the influence of the object such as the human worker H is suppressed. That is, the sensed value measured in the second state represents a value indicating a drift component of the sensed value dependent on the ambient air conditions.

Returning to FIG. 2, the processing device 13 includes an information processing device that controls operations in the first state and the second state. The processing device 13 includes, for example, a CPU, a memory, a communication device, and a storage device, and executes prestored programs to implement various kinds of functions.

The processing device 13 includes a switcher 35 and a corrector 36. The switcher 35 and the corrector 36 are illustrated in FIG. 2 as functional blocks included in the processing device 13.

The switcher 35 performs switching between the first state and the second state of the reference electrode 12. The switcher 35 opens and closes the switch 30b to perform the switching. Specifically, the switcher 35 brings the switch 30b into the open state to place the reference electrode 12 into the first state. Additionally, the switcher 35 places the switch 30b into the closed state to bring the reference electrode 12 into the second state.

Furthermore, the switcher 35 opens and closes the switch 30a according to the switching control. Specifically, by placing the reference electrode 12 into the first state, the switcher 35 brings the switch 30a into the open state. By placing the reference electrode 12 into the second state, the switcher 35 brings the switch 30a into the closed state. That is, in the second state, the capacitor 23a and the capacitor 23b are electrically coupled to each other in parallel to exhibit a combined capacitance. This is because the value of a capacitance created in the detection electrode 25 in the second state is larger than that created in the first state.

The switcher 35, for example, repeats switching between the first state and the second state at a predetermined control interval. It is preferable that each period of time for the first state is set longer than a respective period of time for the second state. A switching timing performed by the switcher 35 is not limited to the above-mentioned timing. For example, the switcher 35 may place the reference electrode 12 in the first state while the robot 4 is in operation and may place the reference electrode 12 in the second state while the robot 4 is not in operation.

The corrector 36 corrects a sensed value measured in the first state using the sensed value measured in the second state. The corrector 36 calculates a difference between the sensed value measured in the first state and the sensed value measured in the second state.

Specifically, the corrector 36 subtracts the sensed value measured in the second state from the sensed value measured in the first state. That is, the corrector 36 suppresses a drift component of the sensed value measured in the first state that changes according to the ambient air conditions. For example, the corrector 36 subtracts the sensed value most recently measured in the second state from the sensed value measured in the first state to thereby suppress the drift component. The sensed value measured in the second state for subtraction may be a single sensed value measured in the second state, or may be an average value of a plurality of sensed values measured in the second state.

The correction process performed in this manner can suppress the influence of the volatile ambient air conditions (drift component), such as a temperature and a humidity. Since the respective sensed values measured in the first state and the second state are output from the identical circuit as illustrated in FIG. 2, it is also possible to suppress the influence of a temperature drift caused within the circuit itself. Since the detection electrode 25 is used commonly in the first state and the second state, it is possible to further suppress the influence of a change caused by the states of the electrode. The states of the electrode include, for example, dirt and condensation on the surface of the detection electrode 25.

The corrector 36 corrects the sensed value measured in the first state, and outputs the corrected sensed value to the control device 5.

In the above embodiment, the description has been given in which the correction operation is performed by obtaining of the difference between the sensed value measured in the first state and the sensed value measured in the second state. However, as long as the sensed value measured in the first state is corrected, using the sensor value measured in the second state, to suppress the drift component caused by the ambient air conditions, a correction method is not limited to the above-described method. For example, a correction method may be performed in which the sensed value measured in the second state is multiplied by a constant ratio and subtracted from the sensed value measured in the first state.

### <Flow of Processing>

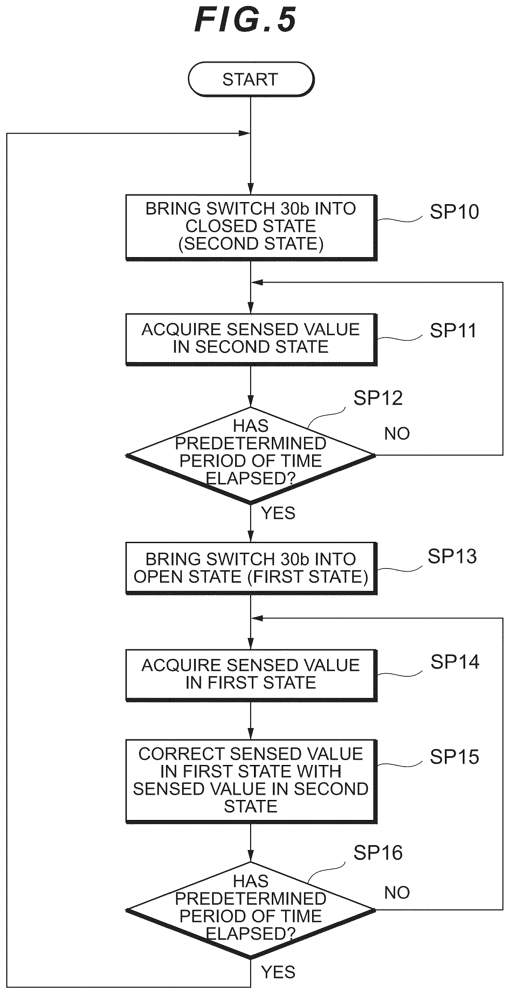

FIG. 5 is a flowchart showing an exemplary flow of correction processing steps according to the present embodiment. Each of the following processing steps is executed, for example, when the operation of the robot 4 is initiated. The order or contents of the following steps can be changed when appropriate.

### (Step SP10)

The switcher 35 places the switch 30b in the closed state to bring the reference electrode 12 into the second state. The process then proceeds to processing in step SP11.

### (Step SP11)

The corrector 36 acquires the sensed value measured in the second state. The process then proceeds to the processing step in step SP12.

### (Step SP12)

The switcher 35 determines whether or not a predetermined period of time has elapsed since the switch 30b is placed in the closed state. In response to a determination that the predetermined period of time has not elapsed, the process returns to step SP11, and the step is executed again. In response to a determination that the predetermined period of time has elapsed, the process then proceeds to step SP13.

### (Step SP13)

The switcher 35 places the switch 30b in the open state to bring the reference electrode 12 into the first state. The process then proceeds to step SP14.

### (Step SP14)

The corrector 36 acquires the sensed value measured in the first state. The process then proceeds to step SP15.

### (Step SP15)

The corrector 36 corrects the sensed value measured in the first state with the sensed value measured in the second state and outputs the corrected sensed value measured in the first state to the control device 5. Specifically, the corrector 36 subtracts the sensed value measured in the second state from the sensed value measured in the first state. For example, the corrector 36 subtracts the sensed value measured in the second state, which is acquired in step SP11, which is executed immediately before the execution of step SP15, from the sensed value measured in the first state.

### (Step SP16)

The switcher 35 determines whether or not a predetermined period of time has elapsed since the switching of the switch 30b into the open state. In response to a determination that the predetermined period of time has not elapsed, the process returns to step SP14, and the step is executed again. In response to a determination that the predetermined period of time has elapsed, the process returns to step SP10, and the step is executed again.

In this manner, the sensed value regarding the object detection is corrected. The control device 5 receives the sensed value, determines, for example, a proximate presence of the object, and uses the determination to control the robot 4.

### <Actions and Effects>

As described above, in the present embodiment, the reference electrode 12 is provided to face the detection electrode 25, and switching is performed between the first state in which the reference electrode 12 is opened and the second state in which the reference electrode 12 is coupled to the reference potential. With this configuration, it is possible to obtain the sensed value representing an object and the sensed value representing the drift component that changes according to the ambient air conditions. As a result, it is possible to correct the sensed value representing the object. since the reference electrode 12 for correction is provided to face the detection electrode 25, the need for, for example, a special arrangement is eliminated, such as installing a shield to prevent the object from being detected, and thus the configuration for correction can be simplified. That is, it is possible to correct the result of object detection that may a change depending on the ambient air conditions, and it is also possible to simplify the configuration for correction.

It becomes possible to correct the sensed value measured in the first state with the sensed value measured in the second state to thereby suppress the drift component of the sensed value measured in the first state.

Although the reference electrode 12 is provided to face the detection electrode 25, it is possible to obtain the sensed value representing to an object near the detection electrode 25 when the reference electrode 12 is opened. In the second state, it is possible to obtain the sensor value representing the drift component.

Furthermore, by providing the detection electrode 25 in the arm of the robot 4, it becomes possible to detect an object with respect to the arm.

### Second Embodiment

A second embodiment will be described below.

In the second embodiment, a description will be given in which a sensed value is corrected using a reference sensor 62. Descriptions of constituents in the second embodiment similar to those described in the first embodiment are omitted. The second embodiment may be combined with the first embodiment.

### <Overall Configuration>

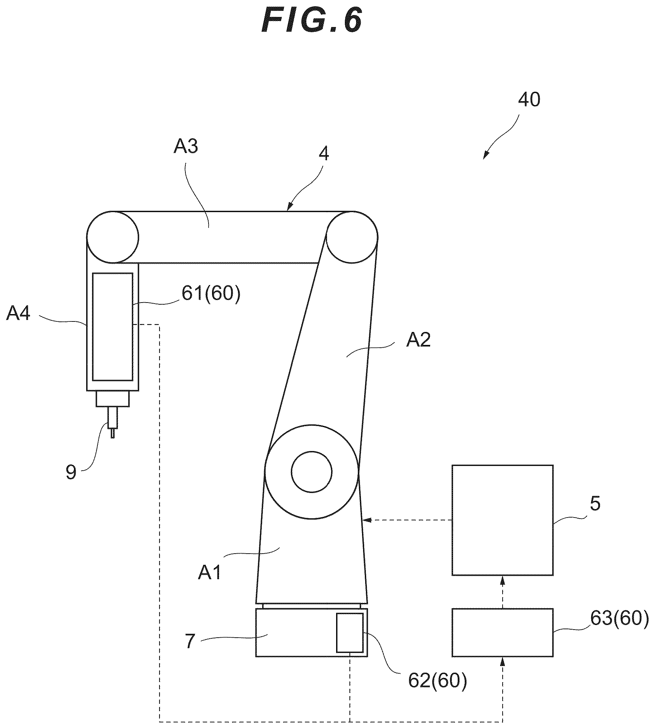

FIG. 6 is a schematic view illustrating an exemplary configuration of a robot system 40 equipped with a sensor 60 as a capacitance sensor according to the present embodiment. The sensor 60 functions as a capacitance sensor and may include a proximity sensor or a displacement sensor. That is, the sensor 60 may be a sensor that detects a proximity or a sensor that detects a displacement. In the present embodiment, a description will be given using the sensor 60 that includes a proximity sensor for example.

The robot system 40 is an industrial robot, and is, for example, a collaborative robot, similar to the robot system 2.

As illustrated in FIG. 6, the robot system 40 mainly includes the robot 4, the control device 5, and the sensor 60.

The sensor 60 is a capacitance sensor that detects an object such as a human worker with respect to the robot 4. The sensor 60 mainly includes a detection sensor 61, a reference sensor 62, and a processing device 63.

The detection sensor 61 is a capacitance sensor that detects, similar to the detection sensor 11, an object presents in a detection area in a predetermined direction. The detection sensor 61 is provided in an arm of the robot 4 (for example, the fourth arm A4). The detection sensor 61 may be provided in another part of the robot 4 or provided in each of a plurality of arms. It is sufficient as long as at least the detection electrode 25 of the detection sensor 61 is provided in the arm, similar to the detection sensor 11. The detection electrode 25 will be described later in detail.

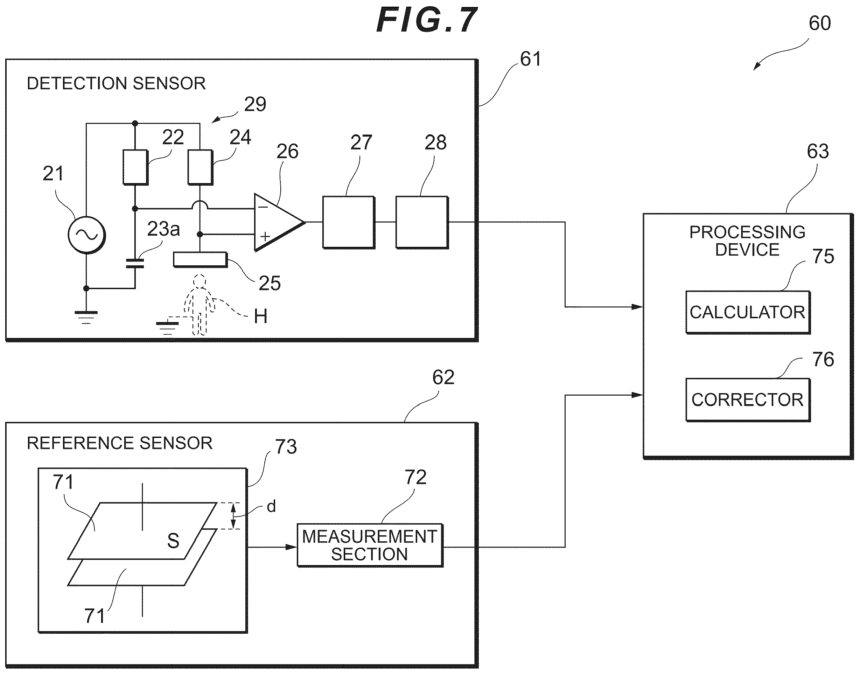

FIG. 7 is a block diagram illustrating an exemplary configuration of the sensor 60. The detection sensor 61 includes the selectable waveform generator 21, the resistor 22, the capacitor 23a, the resistor 24, the detection electrode 25, the operational amplifier 26, the lock-in amplifier 27, and the A/D converter 28, similar to the detection sensor 11. The detection electrode 25 forms part of the RC bridge circuit 29. As long as the sensed value corresponding to the capacitance created by the detection electrode 25 is output, the specific circuit configuration of the detection sensor 61 is not limited to that illustrated in FIG. 7.

The detection electrode 25 creates a capacitance between the detection electrode 25 and an object such as the human worker H. The sensed value output from the detection sensor 61 turns into a value corresponding to the value of the capacitance created between the detection electrode 25 and the object. The sensed value is output to the processing device 63.

Returning to FIG. 6, the reference sensor 62 and the detection sensor 61 are positioned at different locations from each other. Specifically, the detection sensor 61 (or the detection electrode 25 more accurately) and the reference sensor 62 are provided to different members. In the present embodiment, the detection sensor 61 is provided in the fourth arm A4, and the reference sensor 62 is provided in the base 7. For example, the detection sensor 61 is provided in a movable member, and the reference sensor 62 is provided in a fixed (immovable) member. An installation position of the reference sensor 62 is not restrictive.

The reference sensor 62 is preferably positioned not to interfere with the function of the detection sensor 61. That is, the reference sensor 62 is positioned separate from the detection sensor 61 by a predetermined distance or more. Specifically, while the robot 4 is operating, there are chances that the detection sensor 61 (the detection electrode 25 in particular) and the reference sensor 62 come close to each other. The reference sensor 62 is provided at a sufficient distance from the detection sensor 61 so that it is separated from the detection sensor 61 by at least the predetermined distance or more even when the detection sensor 61 and the reference sensor 62 come closest to each other. In this manner, while the robot 4 is operating, at least the predetermined distance between the detection sensor 61 and the reference sensor 62 (measured, for example, linearly) is secured. The predetermined distance is set more than or equal to the range in which the influence of an electric field generated by one of the detection sensor 61 and the reference sensor 62 with respect to the other is permissible. By positioning the detection sensor 61 and the reference sensor 62 separate from each other by the predetermined distance or more, an accidental contact between the detection sensor 61 and the reference sensor 62 can be prevented. The detection sensor 61 and the reference sensor 62 may be positioned to interfere with each other if an appropriate positioning restrictions or the like are imposed.

As illustrated in FIG. 7, the reference sensor 62 includes a pair of electrodes 71 and a measurement section 72.

Two electrodes 71 are provided in pair and form a capacitor 73 in a parallel plate shape. There is air between the electrodes 71 in communication with the air (ambient air surrounding the robot 4). It is more preferable that the air between the electrodes 71 is under the ambient air conditions equal (or close) to the ambient air conditions of the air surrounding the detection sensor 61. An electrode area S of each electrode 71 and a distance d between the electrodes are set in advance at fixed values (design values).

For example, the electrodes 71 may be configured with a specification (for example, an electrode area) that is identical to the specification for the detection electrode 25 of the detection sensor 61 or may be configured to have an area that is smaller than that of the detection electrode 25 of the detection sensor 61. For example, by configuring the electrodes 71 of the reference sensor 62 to have the electrode area smaller than that of the detection electrode 25 of the detection sensor 61, it becomes possible to downsize the entire sensor 60.

The measurement section 72 measures a capacitance Cs in the capacitor 73 formed of the electrodes 71. For example, the measurement section 72 flows a known current Is in the electrodes 71 and measures a time Tc until the voltage between the electrodes 71 reaches a reference voltage Vc. The measurement section 72 then calculates an accumulated charge Qc from the current Is and the time Tc and divides the calculated charge Qc by the reference voltage Vc to obtain the capacitance Cs. That is, the measurement section 72 calculates the capacitance Cs based on a relationship of Cs = (Is × Tc)/Vc. As long as the capacitance Cs created by the electrodes 71 is calculated, a calculation method is not limited to the above-mentioned method. Information regarding the calculated capacitance Cs is output to the processing device 63, which will be described below.

The processing device 63 is an information processing device that corrects detection result information from the detection sensor 61 using reference information from the reference sensor 62. The detection result information represents the sensed value and the reference information represents the dielectric constant ε. The processing device 63 includes, for example, a CPU, a memory, a communication device, and a storage device, and executes stored programs to implement various kinds of functions.

The processing device 63 includes a calculator 75 and a corrector 76. The calculator 75 and the corrector 76 are illustrated in FIG. 7 as functional blocks included in the processing device 63.

The calculator 75 calculates the dielectric constant ε from the capacitance Cs in the reference sensor 62. Specifically, the calculator 75 acquires the capacitance Cs calculated by the measurement section 72. The calculator 75 then calculates the dielectric constant ε based on the capacitance Cs and preset specification information regarding the reference sensor 62. The specification information regarding the reference sensor 62 includes the electrode area S of the electrodes 71 and the distance between electrodes d. The calculator 75 multiplies a ratio of the distance between electrodes d to the electrode area S (d/S) by the capacitance Cs to calculate the dielectric constant ε. That is, the calculator 75 calculates the dielectric constant ε from ε = Cs × (d/S). A method of calculating the dielectric constant ε is not limited to the above-mentioned method.

The dielectric constant ε fluctuates according to the ambient air conditions including a temperature and a humidity. By calculating the dielectric constant ε based on the reference sensor 62 having a known configuration, it becomes possible to obtain the dielectric constant ε corresponding to the ambient air surrounding the robot 4. The calculator 75 outputs the calculated dielectric constant ε to the corrector 76.

The corrector 76 corrects the sensed value measured by the detection sensor 61 based on the dielectric constant ε calculated by the calculator 75. Specifically, taking the dielectric constant ε calculated under reference ambient air conditions as a reference dielectric constant ε0, the corrector 76 corrects the sensed value based on a difference between the dielectric constant ε and the reference dielectric constant ε0. For example, the difference between the dielectric constant ε and the reference dielectric constant ε0, and a correction value for the sensed value are correlated with each other as correction data in a form of table data or in a form a relational equation. The corrector 76 then performs an addition, a subtraction or other arithmetic operations on the sensed value using the correction value derived in relation to a difference value calculated as explained above. Alternatively, a preset conversion equation may be prepared in advance that converts the sensed value into the corrected sensed value according to the difference between the dielectric constant ε and the reference dielectric constant ε0, and the corrector 76 may use the conversion equation to perform the correction.

By performing the correction in this manner, it becomes possible to obtain the sensed value in which the influence of the ambient air conditions, such as a temperature and a humidity, is suppressed. The sensor value is output to the control device 5.

FIG. 6 illustrates an example in which the detection sensor 61 is provided in the fourth arm A4, but the detection sensors 61 may be provided at a respective plurality of positions including the fourth arm A4, the third arm A3, and the like. That is, one reference sensor 62 may be provided with respect to the plurality of detection sensors 61. In such a configuration, the processing device 63 uses the dielectric constant ε calculated from the sensed value from the reference sensor 62 to correct respective sensed values measured from the plurality of detection sensors 61. Alternatively, a plurality of reference sensors 62 may be provided with respect to one detection sensor 61.

### <Flow of Processing>

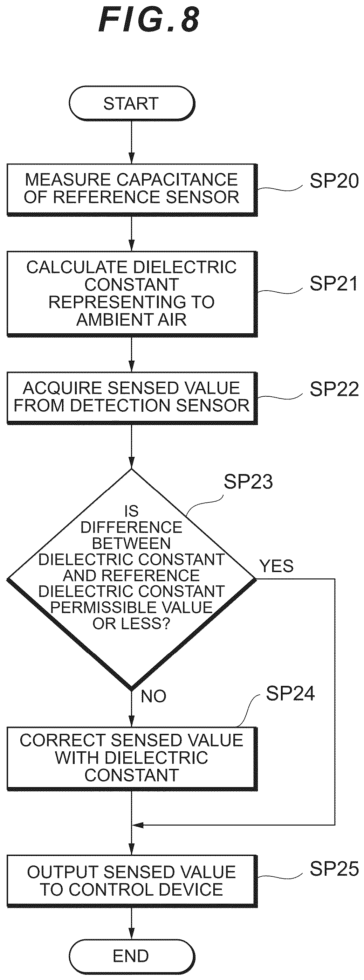

FIG. 8 is a flowchart describing an exemplary flow of correction processing steps according to the present embodiment. Each processing step in the following steps is, for example, repeatedly executed at a predetermined control interval. The order or contents of the following steps can be changed when appropriate.

### (Step SP20)

The measurement section 72 measures the capacitance Cs of the reference sensor 62. The process then proceeds to step SP21.

### (Step SP21)

The calculator 75 calculates the dielectric constant ε representing the ambient air of the robot 4 based on the capacitance Cs. Specifically, the calculator 75 uses the capacitance Cs, and known information on the electrode area S and the distance between electrodes d to calculate the dielectric constant ε from ε = Cs × (d/S). The process then proceeds to step SP22.

### (Step SP22)

The corrector 76 acquires the sensed value measured by the detection sensor 61. The process then proceeds to step SP23.

### (Step SP23)

The corrector 76 determines whether or not the difference between the dielectric constant ε and the reference dielectric constant ε0 is a permissible value or less. In response to a determination that the difference between the dielectric constant ε and the reference dielectric constant ε0 is equal to or less than the permissible value, the process proceeds to step SP25. In response to a determination that the difference between the dielectric constant ε and the reference dielectric constant ε0 is not equal to or less than the permissible value, the process proceeds to step SP24.

### (Step SP24)

The corrector 76 corrects the sensed value with the dielectric constant ε. The process then proceeds to step SP25.

### (Step SP25)

The corrector 76 outputs the sensed value to the control device 5. In response to a determination that the difference between the dielectric constant ε and the reference dielectric constant ε0 is equal to or less than the permissible value, the sensed value is output uncorrected, and in response to a determination that the difference between the dielectric constant ε and the reference dielectric constant ε0 is not equal to or less than the permissible value, a corrected sensed value is output.

In this manner, the sensed value of object detection is corrected. The control device 5 receives the sensed value, determines, for example, a proximity of the object, and uses the determination to control of the robot 4.

### < Advantageous Effects>

As described above, in the present embodiment, the sensor 60 functioning as a capacitance sensor uses the reference sensor 62 including the electrodes 71 paired to have the ambient air between them to correct the sensed value from the detection sensor 61. Hence, although there is a possibility that the sensed value may drift depending on the ambient air conditions, it is possible to correct the drifted sensed value according to the air characteristics of the ambient air conditions. Since the object detection is performed based on the sensed value, it becomes possible to increase the accuracy of object detection. Furthermore, since the reference sensor 62 includes the capacitor 73 including the paired electrodes 71, the need is eliminated for special arrangements for installing a shield or the like to prevent the object from being detected and thus the configuration for correction can be simplified. That is, it is possible to correct an object detection result even with changes in the ambient air conditions, and it is also possible to simplify the configuration for correction. Although the ambient air conditions such as a temperature and a humidity can be directly measured, the measurement accuracy tends to be low. However, the above-mentioned correction method makes it possible to perform correction with high accuracy without directly measuring the temperature and the humidity.

By providing the detection electrode 25 in the detection sensor 61 and the reference sensor 62 as separate members (components), the interference between the detection sensor 61 and the reference sensor 62 can be suppressed.

Additionally, it is possible to use one reference sensor 62 to correct respective sensed values measured by the plurality of detection sensors 61. This eliminates the need for providing the reference sensors 62, respectively, for the detection sensors 61, resulting in downsizing the sensor 60.

If a configuration is taken in which the detection sensor 61 is provided in the arm, and the reference sensor 62 is provided in the base 7, the interference between the detection sensor 61 and the reference sensor 62 can be suppressed. Further, a problem can be avoided in that if the reference sensor 62 is provided in the arm, a region in which the object cannot be detected may be created.

### Modifications

The present invention is not limited to the above-mentioned embodiments. That is, the above-described embodiments even modified with a design change considered routine by one of ordinary skill in the art still fall within the scope of the present invention as long as the modified embodiments practice the features of the present invention. Additionally, the features of the above-described embodiments and the features of the following modifications may be combined as long as combinations are technically feasible, and those combinations still fall within the scope of the present invention as long as the combinations practice the features of the present invention.

For example, in the first and second embodiments, the description has been given in which the sensor 6 or the sensor 60 is provided as a capacitance sensor in the robot 4 for example. However, the capacitance sensor may be positioned in any device other than the robot 4.

In the first and second embodiments, the description has been given in which the control device 5, and the processing device 13 or the processing device 63 have separate functions. However, part or all of functions of the processing device 13 or the processing device 63 may be provided in the control device 5, or part of functions of the control device 5 may be included in the processing device 13 or the processing device 63. For example, the description has been given in which the control device 5 has the function of determining whether or not the object is present in a close proximity to the robot 4 based on the sensed value. However, the function may be included in the processing device 13 or the processing device 63.

In the first and second embodiments, the detection sensor 11 and the detection sensor 61 have been described using specific configuration. However, the detection sensor 11 and the detection sensor 61 are not limited to the specific configurations as long as the specific configurations include the detection electrode 25, and a value representing the capacitance between the detection electrode 25 and the object is output as the sensed value. For example, the detection sensor 11 and the detection sensor 61 may be configured in a form that adopts an oscillation frequency that changes according to a capacitance created between the detection electrode 25 and the object. Even with the configuration, it is possible to correct the sensed value.

In the first embodiment, the corrector 36 subtracts the sensed value measured in the second state, which is acquired in step SP11 immediately before step SP15, from the sensed value in the first state. However, a method of correcting the sensed value in the first state is not limited thereto. For example, the corrector 36 may subtract an average value of a plurality of sensor values measured during the second state, which are acquired during a predetermined period of time in step SP12, from the sensed value measured in the first state.

In the second embodiment, the description has been given in which the reference sensor 62 is provided in the base 7 of the robot 4 for example. However, an installation position of the reference sensor 62 is not limited thereto. For example, the reference sensor 62 may be provided at a position distant from the robot 4 in a space surrounding the robot 4. there is no restriction on the number of installed reference sensors 62. For example, a plurality of reference sensors 62 may be provided, respectively, for a plurality of detection sensors 11.

In the second embodiment, the description has been given in which the dielectric constant ε is calculated from one reference sensor 62 and used to correct the sensed value for example. However, the dielectric constant ε may be calculated based on a plurality of reference sensors 62. For example, a plurality of reference sensors 62 may be provided to surround the robot 4, and the sensed value may be corrected by calculating the dielectric constant ε using one of the plurality of reference sensors 62 located closest to the robot 4. That is, the reference sensor 62 for calculating the dielectric constant ε may be selected according to the operation of the robot 4. Additionally, a plurality of reference sensors 62 may be provided, and the sensed value may be corrected with an average value of the dielectric constants ε calculated respectively from measurement results of the plurality of reference sensors 62. That is, the correction is performed using the plurality of dielectric constants ε obtained from measurement results of the plurality of reference sensors 62.

In the second embodiment, the description has been given in which the dielectric constant ε is calculated, and the sensed value is corrected for example. However, but a timing of calculating the dielectric constant ε and a timing for correction may not be simultaneous. For example, at the time of performing the correction, the dielectric constant ε previously calculated (recently calculated) may be used. In the second embodiment, the correction may be performed based on a difference or the like between an output from the reference sensor 62 and an output from the detection sensor 11, like as performed in the first embodiment.

In the second embodiment, the description has been given in which the reference sensor 62 is fixed in a fixture such as the base for example. However, a mover that moves the position of the reference sensor 62 may be provided. That is, the mover may move the position of the reference sensor 62 according to the operation of the robot 4 to prevent the reference sensor 62 from interfering with the detection sensor 11 mounted on the arm.

In the second embodiment, the processing device 63 may control turning ON/OFF of the reference sensor 62. Specifically, the processing device 63 may turn ON/OFF the reference sensor 62 according to the operation of the robot 4. For example, when the detection sensor 11 comes close to the reference sensor 62 as a result of the operation of the robot 4, the processing device 63 places the operation of the reference sensor 62 on hold. This prevents the calculation of the dielectric constant ε from including the influence on the reference sensor 62 by an electric field generated by the detection sensor 11.

In the first and second embodiments, the description has been given in which the sensor 6 and the sensor 60 use a self-capacitance detection method for example, However, the sensor 6 and the sensor 60 may use a mutual capacitance method. For example, the first embodiment may adopt the detection electrodes 25 for the detection sensor 11 that are formed with two electrodes (a pair of electrodes), and the reference electrode 12 is provided to face the pair of electrodes. The second embodiment may adopt for example the detection electrodes 25 for the detection sensor 61 that are formed with two electrodes (a pair of electrodes). In both cases, an object is detected according to the mutual capacitance method that uses the pair of electrodes that form the detection electrodes 25.

In the first and second embodiments, the description has been given in which each of the processing device 13 and the processing device 63 is an information processing device including the CPU or the like. However, at least part of (or all of) the functions may be implemented in a logic circuit. In this configuration, there are no restrictions on a specific configuration of each of the processing device 13 and the processing device 63.

### [Item 1]

A capacitance sensor (6, 60) comprising:
a detection sensor (11, 61) including a detection electrode (25) and configured to output a sensed value representing a capacitance created between the detection electrode (25) and an object (H);
a reference electrode (12) provided to face the detection electrode (25) and coupled to a reference potential via a switch (30b); and
a processing device (13, 63) configured to open and close the switch (30b) to transition between a first state in which the reference electrode (12) is opened and a second state in which the reference electrode (12) is coupled to the reference potential.

### [Item 2]

The capacitance sensor (6, 60) according to item 1, wherein the processing device (13, 63) is configured to correct the sensed value measured in the first state with the sensed value measured in the second state.

### [Item 3]

The capacitance sensor (6, 60) according to item 1 or 2, wherein
the sensed value measured in the first state is a value representing a capacitance created between the detection electrode (25) and the object (H) via the opened reference electrode (12), and
the sensed value measured in the second state is a value representing a capacitance created between the detection electrode (25) and the reference electrode (12) coupled to the reference potential.

### [Item 4]

A capacitance sensor (6, 60) comprising:
a detection sensor (11, 61) including a detection electrode (25) and configured to output a sensed value representing a capacitance created between the detection electrode (25) and an object (H);
a reference sensor (62) provided at a position that is different from a position of the detection electrode (25) and including electrodes paired via ambient air; and
a processing device (13, 63) configured to calculate a dielectric constant (ε) of the ambient air based on an output from the reference sensor (62) and to correct the sensed value with the calculated dielectric constant (ε).

### [Item 5]

The capacitance sensor (6, 60) according to item 4, wherein the detection electrode (25) of the detection sensor (11, 61) and the reference sensor (62) are provided to separate members.

### [Item 6]

The capacitance sensor (6, 60) according to item 4 or 5, wherein
the detection sensor (11, 61) is provided in plural,
the reference sensor (62) is provided with respect to the plural detection sensors, and
the processing device (13, 63) is configured to use the dielectric constant (ε) calculated from an output from the reference sensor (62) to correct the sensed value measured from each of the plural detection sensors.

### [Item 7]

A robot system (2, 40) comprising:
a base (7);
a plurality of arms provided to the base (7); and
the capacitance sensor (6, 60) according to item 1 or 2,
wherein the detection electrode (25) and the reference electrode (12) are provided in any of the plurality of arms.

### [Item 8]

A robot system (2, 40) comprising:
a base (7);
a plurality of arms provided to the base (7); and
the capacitance sensor (6, 60) according to item 4 or 5, wherein
the detection electrode (25) in the detection sensor (11, 61) is provided in any of the plurality of arms, and
the reference sensor (62) is provided in the base (7).

## Claims

1. A capacitance sensor (6, 60) comprising:
a detection sensor (11, 61) including a detection electrode (25) and configured to output a sensed value representing a capacitance created between the detection electrode (25) and an object (H);
a reference sensor (62) provided at a position that is different from a position of the detection electrode (25) and including electrodes paired via ambient air; and
a processing device (13, 63) configured to calculate a dielectric constant (ε) of the ambient air based on an output from the reference sensor (62) and to correct the sensed value with the calculated dielectric constant (ε).

2. The capacitance sensor (6, 60) according to claim 1, wherein the detection electrode (25) of the detection sensor (11, 61) and the reference sensor (62) are provided to separate members.

3. The capacitance sensor (6, 60) according to claim 1 or 2, wherein
the detection sensor (11, 61) is provided in plural,
the reference sensor (62) is provided with respect to the plural detection sensors, and
the processing device (13, 63) is configured to use the dielectric constant (ε) calculated from an output from the reference sensor (62) to correct the sensed value measured from each of the plural detection sensors.

4. A robot system (2, 40) comprising:
a base (7);
a plurality of arms provided to the base (7); and
the capacitance sensor (6, 60) according to claim 1 or 2, wherein
the detection electrode (25) in the detection sensor (11, 61) is provided in any of the plurality of arms, and
the reference sensor (62) is provided in the base (7).
